# EUROPEAN PATENT SPECIFICATION

(11) **EP 0 714 119 B1**
(45) Date of publication and mention of the grant of the patent: **04.12.2002**
(21) Application number: 95203233.2
(22) Date of filing: 08.05.1991
(51) Int. Cl.: H01L 21/033, H01L 21/308, H01L 21/321, G03F 7/16

(54) **Pattern forming process and process for preparing semiconductor device utilizing said pattern forming process**
Verfahren zur Erzeugung einer Struktur und Verfahren zum Vorbereiten einer halbleitenden Anordnung mit Hilfe dieses Verfahrens
Procédé pour former un motif et procédé de préparation d'un composant semi-conducteur utilisant ledit procédé

(30) Priority: 09.05.1990 JP 11764490; 10.05.1990 JP 11867590; 19.06.1990 JP 15868790; 03.07.1990 JP 17444390; 16.11.1990 JP 30855090
(43) Date of publication of application: 29.05.1996
(62) Divisional of application: 91304134.9
(73) Proprietor: CANON KABUSHIKI KAISHA, Tokyo (JP)
(72) Inventor: Yagi, Takayuki, Ohta-ku, Tokyo (JP); Komatsu, Toshiyuki, Ohta-ku, Tokyo (JP); Sato, Yasue, Ohta-ku, Tokyo (JP); Kawate, Shinichi, Ohta-ku, Tokyo (JP)
(74) Representative: Beresford, Keith Denis Lewis

(56) References cited:
- EP-A- 0 204 538
- WO-A-89/07285
- FR-A- 2 077 574
- US-A- 4 348 473
- US-A- 4 698 238
- JOURNAL OF VACUUM SCIENCE AND TECHNOLOGY: PART B, vol. 7, no. 4, August 1989 NEW YORK US, pages 621-626, XP 000168951 ANTHONY ET AL 'In situ cleaning of silicon substrate surfaces by remote plasma-excited hydrogen'
- APPLIED PHYSICS LETTERS, vol. 56, no. 1, 1 January 1990 NEW YORK US, pages 98-100, XP 000126795 TANEYA ET AL 'Photo-oxidation of GaAs for in situ patterned-mask formation prior to chlorine gas etching'
- JAPANESE JOURNAL OF APPLIED PHYSICS, vol. 28, no. 7, July 1989 TOKYO JP, pages L1274-L1277, XP 000073560 TAKAKUWA ET AL 'Low-temperature cleaning of HF passivated Si(111) surface with VUV light'
- IBM TECHNICAL DISCLOSURE BULLETIN, vol. 13, no. 3, August 1970 NEW YORK US, page 752 'Antireflective Chrome photomasks'

## Description

This invention relates to a pattern forming process, more particularly to a process of forming a pattern by etching, a semiconductor, a metal or an insulator, particularly to a process of forming a fine etching pattern suitable for an electronic device, and a process of producing a semiconductor device utilising this pattern forming process.

In recent years, with the enlargement of the aperture of an exposure device to be utilised in pattern forming technique utilising photolithographic technique, a large area device, for example, a flat panel such as an active matrix liquid crystal display, a direct current plasma display, etc. is going to be commercially produced.

Photolithography includes steps of coating the predetermined surface of a material to be worked with a photoresist, subjecting the photoresist to treatments including pattern exposure, developing the exposed photoresist to form a resist pattern, and etching by using a solvent or utilising a physical or chemical reaction in gas phase while using the resist pattern as a mask.

Whereas, in the case of a VLSI chip, since the chip is formed by preparing some ten or more chips on one wafer at the same time in an integrated state and cutting the wafer by dicing, it is possible to select effective chips and to discard the defective chips on the wafer. In contrast, in the case of a large area device, the number of the chips produced from one wafer is no more than 1 to several. Only by modifying the device design to reduce the total number of resist masks necessary for pattern formation utilising photolithography, and by optimisation of the design rules, etc., it is possible to improve yield, which is one of the primary factors-for determining device cost.

Thus, in the preparation steps of semiconductor devices, the choice of process of forming the device structure by applying fine working to the sample substrate according to a desired pattern, is important. As described above, in photolithography, complicated and cumbersome processes such as resist coating, pattern exposure, developing, etching, resist peel-off, etc. have been generally employed.

And, as described above, as represented by a semiconductor memory device in recent years, enhancement of memory capacity and performance of the device have been rapidly progressed, whereby the circuit pattern is becoming finer and the circuit structure more complicated. On the other hand, display devices such as liquid crystal displays, plasma displays, are becoming larger, and device functions are becoming more complicated. Accordingly, when these devices are prepared by photolithography, due to the more complicated process itself, the cost is increased. Further, due to generation of dust, etc., the yield is lowered, and the cost is increased as a whole.

In view of the state of the pattern formation technique utilising photolithography as described above, it has been attempted to develop pattern formation techniques without using photolithography.

There has been proposed a method utilising an optical process (see "Examination Research Report Concerning New Electronic Materials XIII" 62-M-273, Society of Electronic Industry Promotion of Japan). This is a photoetching process which effects etching at a photoirradiated portion by a site selective photoirradiation of the material to be worked in a vacuum capable of maintaining a clean environment. None of the photolithography steps of coating resist, pattern exposure, and developing resist are utilised. Thereby, a higher yield can be expected, there is little ionic shock, and also a great cost reduction is possible by reducing materials cost. Thus, this process has attracted attention as an excellent pattern forming process.

As one example of photoetching processes, there has been known a process in which, by selectively irradiating an excimer laser to a phosphorus doped polycrystalline silicon substrate in an atmosphere of chlorine gas and methyl methacrylate. A polymerised film is formed at the non-irradiated portion and the portion irradiated with only a small irradiation dose, while no polymerised film is formed at the portion irradiated with a large irradiation dose. The substrate is etched by chlorine radicals to form a pattern (SEMI Technol. Symp. 1985, P. F-3-1).

Another photoetching technique is described in Sekine, Okano, Horiike: The Fifth Dry Process Symposium Lecture Pretext, p. 97 (1983). As therein described, a substrate with a polysilicon (p-Si) film thereon is set within a reaction chamber where chlorine gas is introduced, UV-ray is selectively irradiated through a photomask to the Si substrate by setting the photomask, having a light shielding pattern, parallel to the substrate surface. Etching proceeds only at a region where UV-ray is irradiated to form a pattern on the p-Si film. By use of the phototreatment apparatus utilising the process, the photolithography steps of resist coating, developing, resist peel-off, etc. can be obviated to simplify the steps, improve the yield and reduce the cost to a great extent. Further, etching without the generation of damage by ion irradiation (which is a problem in the reactive ion etching of the prior art)
is rendered possible.

Nevertheless, the photoetching processes described above still have various problems to be solved.

For example, as compared with the electron impingement dissociation area of the molecules in the plasma in the dry etching of the prior art, in photoetching the light absorption cross-section of the molecules is smaller by about 1 to 2 orders, and therefore the amount of the radicals which are reactive molecules or atoms having dangling bonds necessary for etching is small. For this reason, it is required to increase the irradiation dose.

However, by the photoirradiation apparatus presently available, a sufficiently satisfactory irradiation dose cannot be obtained, and thus photoirradiation for a long time is required.

For example, J. Vac. Sci. Technol., B3 (5), 1507 (1985) discloses the acceleration of etching by use of an excimer laser which is a large output laser. But the irradiation area in this method is about some ten mm square. For example, when the treatment area is about A4 size, the time required for the etching treatment will be one hour or more.

For obtaining a sufficient irradiation dose in the photoetching, the realization of enlarging a laser aperture and a laser output must be awaited, and it is difficult under the present situation to apply photoetching to the fine working process for the sheet system high speed etching accompanied with the enlargement of the device.

As a process for improving such problems in the photoetching, the process in which a high speed etching is performed by combining photoetching with plasma etching has been proposed.

This process comprises selectively irradiating an excimer laser to the surface of a material to be worked by etching while decomposing a gas of a hydrocarbon compound of which a part or all of the hydrogens is substituted with halogen atoms to deposit a polymerized film thereon, decomposing and removing the polymerized film at the photoirradiated portion, and further etching the surface of the material to be worked consequently exposed by halogen element radicals, thereby obtaining an etching pattern corresponding to the photoirradiated pattern (Japanese Patent Application JP-A-62-219525).

However, even in such process, the photoirradiated area is narrow as several ten mm square, and the etching speed is about some 1.67 nm/s (1000 Å/min), the improvement of one order or more as compared with the photoetching as described above is not desired, and it could be unsatisfactory to apply to the fine working process for sheet system high speed etching accompanied with the enlargement of the device.

The main preparation steps of semiconductor devices are the steps of forming a film of metal, semiconductor or insulator on the substrate and fine working the film to a desired pattern. Presently, in the film forming step and the etching step of performing the fine working for the preparation of these semiconductor devices, the main step comprises, rather than the step using a solution, a so-called dry step using a plasma or excited gas in vacuum or reduced pressure gas. However, for carrying out a desired fine working, in the photolithographic process generally employed, as described above, the complicated processes such as resist coating, pattern exposure, development, etching, resist peel-off, etc. have been employed. However, since a solution is used in the resist coating, developing, resist peel-off steps, all the steps cannot be made dry steps.

Since in the semiconductor preparation steps as described above the steps of performing in vacuum, in solution and in air are mixed therein, the surface of the samples will be oxidised and also preliminary steps for the subsequent steps are required (e.g. steps of evacuating for providing the sample under a reduced pressure state, washing and drying after a solution treatment), whereby there is the problem that the number of steps may be increased and the steps become complicated. Also, the movement amount of the samples between the respective preparation apparatuses will be increased, whereby losses in both time and space are increased. The increase of step number, complicatedness of the steps, increase of movement amount of samples involve the problem of increasing the attachment of dust. Further, by use of a resist and peel-off thereof, the resist peeled off becomes a dust to be attached on the sample surface, whereby there is a problem that the performance of the device is deteriorated and also the yield is lowered.

The present invention has been accomplished in view of the problems in the various etching techniques described above, and its object is to provide a process of forming a patterned portion having resistance to etching by utilising photoirradiation without utilising photolithography, and forming an etching pattern at a high yield and at a low cost.

Another object is to provide a process of forming an etching pattern capable of accomplishing a high yield, a low cost and shortening the time required for the preparation steps to a great extent by using the method comprising a combination of the film formation of a polymerised film by CVD and patterning utilising the photoirradiation of the polymerised film in place of the photolithography for formation of the resist pattern, and separately practising the formation step of the resist pattern comprising the polymerised film and the etching treatment step, each by the chemical action of radicals.

In addition, it is also another object of the present invention to realise a process of producing a semiconductor device which can prevent oxidation of the surface, reduce the preparation steps and the movement amount of the device, improve the device performance and improve yield.

In common with United States Patent US-A-4698238, the process of forming an etching pattern of the present invention is one in which a resist pattern is formed on a surface of a member, and the surface of the member is etched with the formed resist pattern as a mask to form the etching pattern in the member, the process comprising the following sequence of consecutive steps:
a step of forming a film of resist material by forming a polymer film incapable of being etched with halogen element radicals on the surface of the member by chemical vapour deposition (CVD) using, as starting material, a compound obtained by substituting a part or all of the hydrogen atoms constituting a hydrocarbon compound with at least one selected from fluorine or chlorine;
a step of forming a resist pattern which includes selectively irradiating a portion of the formed polymer film, that is to be removed, with light, whereby the polymer film is patterned into a desired pattern; and
a step of dry etching the surface of the member exposed by the resist pattern using the polymer film resist pattern as a mask and utilising halogen element radicals as etchant species.

In the process described in US-A-4698238, the polymer film is formed from tetrafluoroethylene gas using a microwave discharge to promote polymerisation. This film is selectively irradiated with a KrF laser light through a photomask after halting introduction of the tetrafluoroethylene source gas into the film forming chamber.

The process of the present invention is characterised in that said process is an all-dry process in which:
said step of forming the film of resist material is preceded by a step of cleaning or modifying the surface of the member, which comprises cleaning the surface of the member with a plasma obtained using either hydrogen gas or an inert gas or modifying the surface of the member by irradiating it with hydrogen ions or fluorine ions;
said step of forming the resist pattern is performed by selectively irradiating said portion of the formed polymer film in an atmosphere containing oxygen atoms, thereby generating oxygen radicals to decompose and remove the light irradiated portion of the polymer film with the radicals generated by the light irradiation; and
said sequence of steps, including said step of cleaning or modifying the surface of the member, is performed in a state continuously shielded from air and under reduced pressure.

It is acknowledged that an all dry process of forming an etching pattern is disclosed in International Patent Application WO-A-89-07285. As therein disclosed, after cleaning the substrate surface, a polymer film such as AZ 13 50J polymer photoresist (Shipley Mfg. Co.) is sputtered onto the substrate surface and is then irradiated by an ArF excimer laser in a reactive oxygen vapour atmosphere. The substrate is then etched, using the patterned resist as a mask, by reactive ion etching (RIE). Another process is disclosed in which polymethyl methacrylate (PMMA) is deposited by chemical vapour deposition and patterned by laser-assisted etching. In this case laser light, from an excimer laser, is used to image a mask reticle on the PMMA-coated substrate. The substrate, which is of GaAs, is then etched selectively, e.g. using a hot jet of Cl₂ gas.

In the aforesaid process it is thus possible to form the etching pattern with a high yield, since there is employed a combination of film formation of a polymerised film by CVD which can easily accomplish a high yield and patterning of the polymerised film by site selective light irradiation which also is of high yield.

In the process of the present invention, photoirradiation is not utilised for etching as in photoetching, but for patterning of the polymerised film formed by CVD. This can be practised by use of conventional photoirradiation apparatus.

Also, by independently performing the formation step of etching the resist utilising photoirradiation and radicals and the dry etching treatment step by radicals, it becomes possible to shorten the time required for the formation of the etching pattern to a great extent.

Since the respective steps of forming the etching pattern are performed in a state shielded from air and under reduced pressure, oxidation of the substrate and attachment of dust can be prevented, simultaneously with reduction of the number of steps. Further, since the etching is effected by use of a resist mask formed by selective photoirradiation and action of radicals, there will be no generation of dust as no resist is peeled off.

In the accompanying drawings:
Fig. 1 and Fig. 2 are schematic illustrations of apparatus which can be used for the process of the present invention;
Fig. 3 is an illustrative plan view of preparation apparatus;
Figs. 4 through Fig. 8 are schematic sectional views respectively illustrating a cleaning chamber, a sputtering film forming chamber, a plasma film forming chamber, an etching chamber and a light exposure chamber of the apparatus of Fig. 3;
Fig. 9 is a schematic sectional view of a photomask which can be used in pattern forming apparatus for defining the pattern of selective irradiation; and
Fig. 10 is a schematic sectional view showing a constitutional example of the pattern forming apparatus by use of the selective irradiation light of the present invention.

A preferred embodiment will now be described.

The material to be worked has a portion to be etched consisting of a material which can be etched in the etching treatment as described below.

As the portion to be worked, various materials for semiconductor devices, particularly metals such as Al, Si, Cr and Au, semiconductors such as CdS, GaAs and Ge, various insulating materials, can be utilised.

As the portion to be worked, for example, there may be exemplified those formed by forming thin films comprising semiconductors, insulators or various metals formed on an appropriate substrate by thin film formation technique such as vacuum vapour deposition, CVD, sputtering, ion plating method, etc.

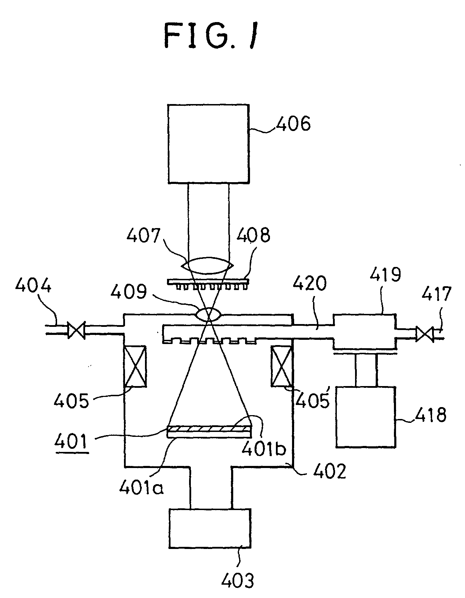

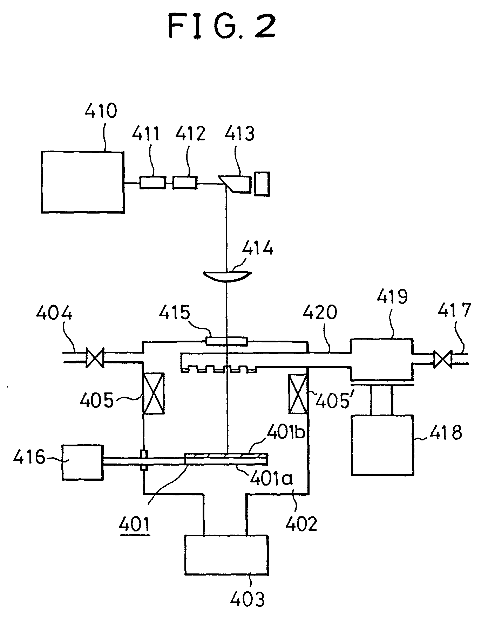

In Fig. 1 and Fig. 2, those having a thin film 401b comprising semiconductor, insulator or various metals formed on an appropriate substrate 401a by a thin film forming technique are exemplified.

First, as shown in the drawings, the material to be worked 401 is set at a predetermined position within a vacuum vessel 402.

In the case of the thin film 401b, if it were to come into contact with air, a naturally oxidised film, water, organic adherents, etc. would be formed on its surface in many cases. Accordingly, a treatment for cleaning or modifying the surface of the thin film 401b is generally required. Indeed, for effecting the site selective etching with a good precision on the surface to be etched, it is very important that the surface to be etched is cleaned or modified.

For the cleaning treatment, there is utilised a method in which an inert gas or hydrogen gas is introduced through the gas introducing pipe 404 into the vacuum vessel 402 which has been evacuated by the evacuation device 403, and a plasma is generated by actuation of the plasma generators 405 and 405' to remove the naturally oxidised film, water, organic adherents, etc. on the thin film 401b surface.

As an alternative, or additionally, a surface modifying treatment is performed by irradiating the surface, or cleaned surface, of the formed thin film with hydrogen ions or fluorine ions. The effect of this surface modification is to make natural oxidation and adhesion of water and other adherents difficult.

Next, a resist pattern is provided on the thin film 401b surface by CVD. A polymerised film capable of being patterned by photoirradiation and radical action is formed by CVD, and then the predetermined portion of the polymerised film is selectively removed by utilising photoirradiation to form a resist pattern with a desired shape.

More specifically, for example, a gas capable of forming a polymerised film by decomposition with plasma is introduced from the gas introducing pipe 404 in the apparatus shown in Fig. 1 and Fig. 2 into the vacuum vessel 402,and subjected to plasma decomposition by the plasma generators 405 and 405' to form a polymerised film with the plasma decomposed product of the gas introduced onto the thin film 401b.

Alternatively, a gas capable of forming a polymerised film by decomposition with plasma is introduced through the gas introducing pipe 417 into the vacuum tank 402, a microwave is excited by the microwave oscillated from the magnetron 418 in the plasma tube 419, and a polymerised film of the decomposed product formed by the microwave on the thin film 401b through the transporting pipe 420 is formed.

The polymerised film thus formed is then patterned utilising oxygen radicals generated by photoirradiation.

Accordingly, a gas capable of generating oxygen radicals by photoexcitation is introduced through the introducing pipe 404 into the vacuum tank 402, and photoirradiation is effected on the polymerised film corresponding to a desired pattern to generate the radicals of the introduced gas at the photoirradiated portion. The polymerised film is decomposed and removed by the action of the radicals, while the non-irradiated portion is left selectively on the thin film 401b surface. A resist pattern is thus obtained.

For the site selective photoirradiation in the patterning method as described above, for example, the projection exposure system shown in Fig. 1 and the laser direct drawing system shown in Fig. 2 can be utilised.

In the projection exposure system, as shown in Fig. 1, the exposure pattern possessed by an exposure mask 408 is projected to form an image by the light from a light source 406 passed through the optical system including lenses 407 and 408, to effect a patterned exposure of the polymer film on the thin film 401b surface.

On the other hand, in the direct drawing system, as shown in Fig. 2, the continuous laser beam oscillated from a laser beam source 410 passes through an optical modulator 411, a collimator lens 412 and a rotatory multi-planar mirror 413, and exposure is effected by a spot image formation on the surface of the thin film 401b within the vacuum vessel 402 by a lens 414 from a window 415. The site selective photoirradiation in the laser direct drawing system can be performed by scanning the image forming position of the laser beam modulated by the optical modulator 411 in a direction parallel to the thin film 401b surface by rotation of the rotatory multi-planar mirror 413, at the same time moving the image forming position of the laser beam by delivering the material to be worked 401 in a direction vertical to the scanning direction of the image forming position by use of a delivery system 416 of the material to be worked, and controlling the scanning by the rotatory multi-planar mirror, the delivery of the material to be worked, and the timings of irradiation and non-irradiation of the laser.

The light source for photoirradiation to be used in the process of the present invention, in the method as described above, can be chosen suitably depending on the kind of the substance for decomposition of the polymerised film.

As the substance capable of generating oxygen radicals by the light for decomposition of the polymerised film, for example, a compound capable of forming oxygen radicals such as nitrogen dioxide, nitrous oxide, or carbon dioxide can be preferably utilised, and the above-described operations can be done by introducing one or more of these gases into the vacuum vessel 402. Alternatively, or additionally, oxygen or ozone can be introduced as an oxygen radicals source.

As the light source, one capable of generating a light having a wavelength of UV-ray absorption end wavelength of the photoradical forming substance can be utilized without any limitation.

For example, when oxygen gas is used as the photoradical forming substance, since the UV-ray absorption end wavelength in its radical generation is about 242 nm, light sources which generate light having shorter wavelength than that can be utilized, rare gas excimer laser, rare gas halide excimer laser, etc. are utilized.

On the other hand, when nitrogen dioxide gas is used as the radical forming substance, since the UV-ray absorption end wavelength in its radical regeneration is near 400 nm, for example, in addition to excimer lasers such as rare gas excimer laser, rare gas halide excimer laser, etc., continuous oscillation laser such as argon ion laser, krypton ion laser, He-Cd laser, etc. can be utilized, whereby there are included the advantages such that choice of light source can be expanded and also that handling is easy.

The polymerized film for formation of the resist pattern is formed by CVD using, as starting material, a compound which is a hydrocarbon compound substituted with at least one selected from fluorine and chlorine for a part or all of the hydrogens thereof.

As the starting material for formation of the polymerized film, compounds such as CF₂Cl₂, CF₃Cl, CCl₄, C₂Cl₂F₄, CH₃Cl, CH₃F, CF₄, C₂F₆ And the like and/or those compounds diluted with a diluting gas such as Cl₂, H₂, or a hydrocarbon or substituted hydrocarbon compound (e.g. C₂H₂, C₂F₆, etc.).

The resist pattern comprising the polymerised film formed by CVD as described above cannot be etched with halogen element radicals for etching such as fluorine radicals, chlorine radicals or the like.

Next, unnecessary residual gas, etc. is discharged from the vacuum vessel 402 by the evacuation device 403 to set the vacuum vessel 402 internally to a predetermined vacuum degree, whereupon a gas for etching is introduced through the gas introducing pipe 417 and is excited in the plasma tube 419 by the microwave oscillated from the magnetron 418 to be introduced through the transporting pipe 420 into the vacuum vessel 402.

As the gas for etching, a gas capable of generating halogen element radicals such as chlorine radicals or fluorine radicals, e.g. Cl₂, CF₃CL, CCl₄ or NF₃, is utilised.

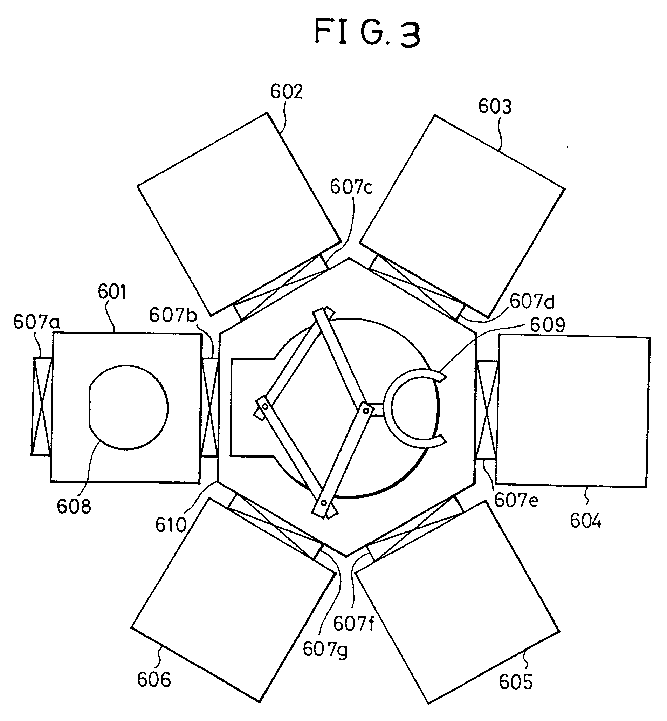

Fig. 3 is a schematic upper view showing the constitution of an apparatus suitable for applying the process described above, which is used for forming a pattern on a sample 608.

In Fig. 3, 601 is a loadlock chamber for introducing and taking out the sample 608, and 602 a cleaning chamber for cleaning the surface of the sample 608 by use of plasma. 603 is a sputtering film forming chamber for forming a film of a metal by sputtering. 604 is a plasma film forming chamber for forming an insulating film and semiconductor film by plasma. 605 is an etching chamber for effecting the chemical dry etching of the film. 609 is a conveyor for conveying a sample 608 by way of a conveying mechanism not shown, and is provided within a conveying chamber 610. 606 is a light exposure chamber for irradiating and patterning polymer resist.

The loadlock chamber 601, the cleaning chamber 602, the sputtering film forming chamber 603, the plasma film forming chamber 604, the etching chamber 605, the light exposure chamber 606 and the conveying chamber 610 are all vacuum-tight and equipped respectively with vacuum evacuation devices (not shown) for evacuating the chambers. The loadlock chamber 601, the cleaning chamber 602, the sputtering film forming chamber 603, the plasma film forming chamber 604, the etching chamber 605 and the light exposure chamber 606 are respectively arranged around the conveying chamber 610, and communicated to the conveying chamber 610 respectively through gate valves 607b to 607g. The loadlock chamber 601 is also provided with, in addition to the gate valve 607b communicated to the conveying chamber 610, the gate valve 607a for taking in and out the sample 608 between the chamber and outside.

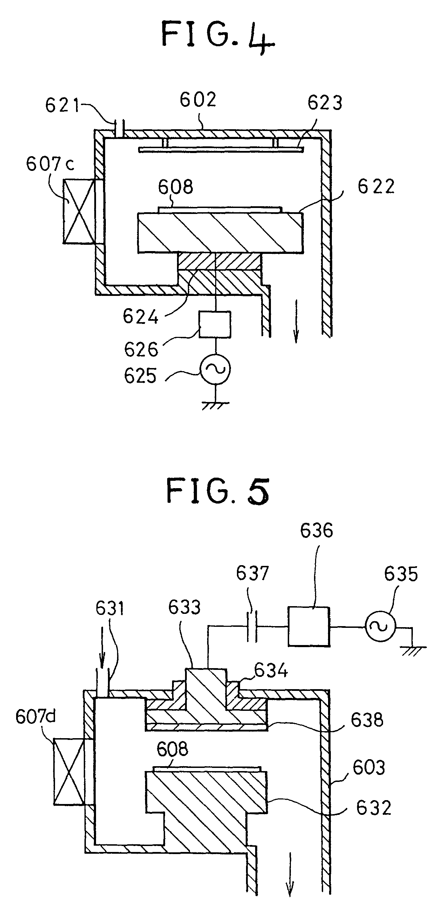

Fig. 4 through Fig. 7 are respectively schematic sectional views for illustrating the constitutions of the cleaning chamber 602, the sputtering film forming chamber 603, the plasma film forming chamber 604, the etching chamber 605 and the light exposure chamber 606 in Fig. 3.

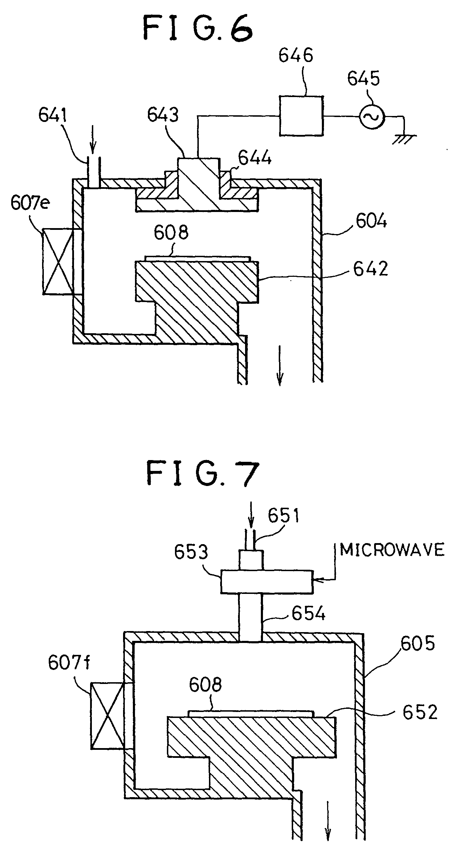

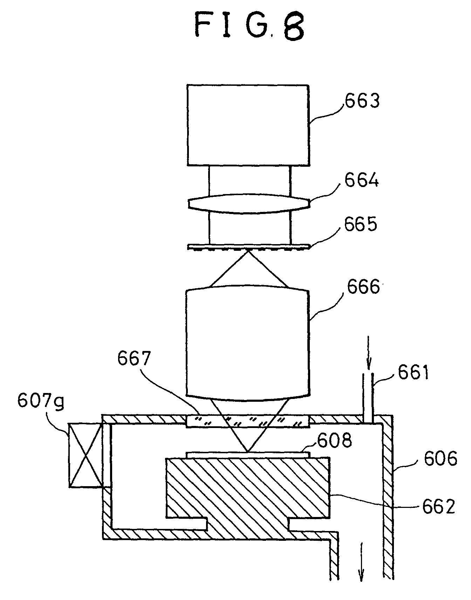

Fig. 4 shows the cleaning chamber 602. In the same Figure, 621 is a gas introducing inlet provided above the cleaning chamber 602 for introducing cleaning gas into the cleaning chamber 602, 622 a sample holding stand for holding the sample 608 placed in the cleaning chamber 602, 623 a counter-electrode opposed to the sample holding stand 622, 624 an insulator for insulating the sample holding stand 622 from the vacuum vessel constituting the cleaning chamber 602, 625 a high frequency power source of 13.56 MHz, 200 W, which is connected to the sample holding stand 622. 626 is a matching box for matching impedances of the sample holding side and the high frequency power source side. Fig. 5 shows the sputtering film forming chamber 603. In the same Figure, 631 is a gas introducing inlet for introducing the sputtering gas into the sputtering film forming chamber 603, 632 is a sample holding stand for holding the sample 608 placed in the sputtering film forming chamber 603, 633 is a counter-electrode provided as opposed to the sample holding stand 632 and applied with high frequency power, 634 an insulator for insulating the counter-electrode 633 from the vacuum vessel constituting the sputtering film forming chamber 603, 635 a high frequency power source of 13.56 MHz and 500 W, 636 a matching box for matching impedances of the sample holding stand 632 side and the high frequency power source 635 side, 637 a condenser for isolating the counter-electrode 634 from direct current, and 638 a sputtering metal. Fig. 6 shows the plasma film forming chamber 604. In the same Figure 641 is a gas introducing inlet for introducing the deposition gas into the plasma film forming chamber 604, 642 a sample holding stand for holding the sample 608 placed in the plasma film forming chamber 604, 643 a counter-electrode provided opposite to the sample holding stand 642 and applied with high frequency power, 644 an insulator for insulating the counter-electrode 643 from the vacuum vessel constituting the plasma film forming chamber 604, 645 a high frequency power source of 13.56 MHz and 350 W, and 646 a matching box for matching impedances of the sample holding stand 642 and the high frequency power source 645. Fig. 7 shows the etching chamber 605. In the same Figure, 652 is a sample holding stand for holding the sample 608 placed in the etching chamber 605, 653 a microwave plasma gas excitation device for generating the excited gas to be fed into the etching chamber 605, 651 a gas introducing inlet for feeding the etching gas to the microwave plasma gas excitation device, 653, 654 a transporting pipe for transporting the excited gas generated in the microwave plasma gas excitation apparatus 653 to the etching chamber 605 and is provided at a position opposed to the sample holding stand 652. Fig. 8 shows the light exposure chamber 606. In the same Figure, 661 is a gas introducing inlet for introducing gas into the light exposure chamber 606, 662 a sample holding stand for holding the sample 608 set within the light exposure chamber 606, 663 a KrF excimer laser which is the light source, 664 a illuminating optical system for illuminating a mask 665 as described below by the generated light at the light source 663, 665 a patterned mask (or reticle) of Cr on a quartz plate, 666 a projection optical system for forming an image of the mask pattern on the surface of the sample 608, 667 a window for introducing the light coming out from the projection optical system 666 into the light exposure chamber 606. Of the respective devices as described above, the light source 663, the illumination optical system 664, the mask 665, the projection optical system 666 are provided above the light exposure chamber 606.

By making the apparatus constitution as described above, the respective steps for preparing a semiconductor device can be carried out consistently while maintaining a state excluding air and reduced in pressure. By doing so, a semiconductor device improved in performance can be prepared without oxidation of the surface of the member to be treated. Also, preliminary steps such as steps of vacuum evacuation from atmospheric pressure ordinarily performed between the respective steps, and also steps of washing and drying after solution treatment are omitted, whereby the productivity is improved. Further, the number of steps and the amount of movement between steps can be reduced to reduce the chances of attachment of dust, and also the generation of dust due to resist peel-off does not occur, whereby the yield is improved.

The apparatus described by referring to Fig. 3 to Fig. 8 is not limited by the constitution as described above, but can be modified. Particularly, although the conveying chamber 610 is surrounded by the respective chambers, it may have a linear configuration in which the respective chambers are arranged in series and provided with the conveying chamber. It is also possible to make the conveying chamber movable, thereby making it connectable and releasable for each chamber.

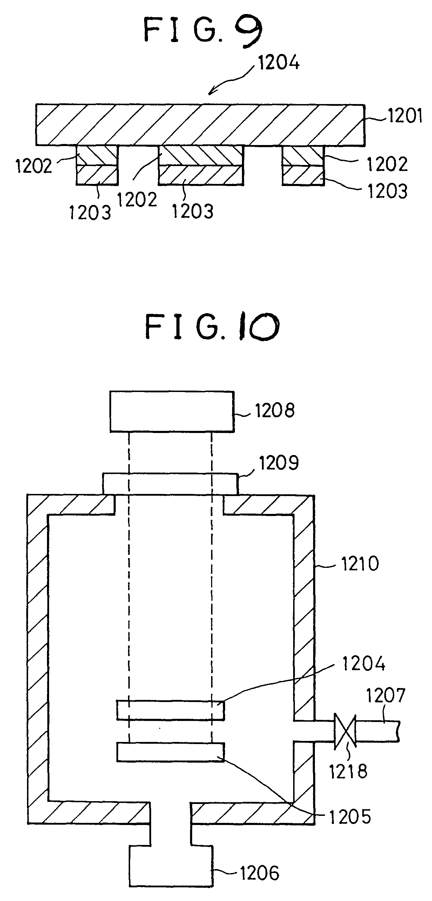

Fig. 9 is a schematic sectional view of a photomask which can be used in pattern formation apparatus and Fig. 10 a schematic sectional view showing an example of a pattern formation apparatus.

The photomask 1204 to be used in this Example-has the desired light-shielding pattern 1202 formed of a metal, on a light-transmissive substrate 1201. A light absorbing member 1203 having the same pattern as the light-shielding pattern 1202 is formed in contact with the light-shielding pattern 1202.

The pattern formation apparatus, as shown in Fig. 10, has a light source 1208 and a treatment vessel 1210 having a light-transmissive window 1209 for transmitting light irradiated from the light source 1208, connected with a gas introducing pipe 1207 and an evacuation device 1206. The above photomask 1204 and the polymer film coated sample substrate 1205 are set in parallel and proximate to each other within the above treatment vessel 1210, and by opening of the valve 1218, a predetermined gas (source of oxygen radicals) is introduced from outside through the above gas introducing pipe 1207 into the above treatment vessel 1210. After the pressure within the above treatment vessel 1210 is maintained at a predetermined value by the above evacuation device 1206, light is selectively irradiated through the above light-transmissive window 1209 and the above photomask 1204 to the above sample substrate 1205, whereby the region of the polymer film on the sample substrate 1205 that is irradiated by light is removed by oxygen radicals to form a predetermined pattern.

At this time, the light reflected on the above sample substrate 1205 is returned to the above photomask 1204. But since the photomask 1204 has already the above light absorbing member 1203 formed with the same shape as the above light-shielding pattern 1202, the above-mentioned reflected light is absorbed in the light absorbing member 1203, and therefore it is not reflected on the above photomask 1204 and returned to the above sample substrate 1205. Accordingly, a predetermined pattern can be formed with a good precision on said sample substrate 1205.

By constituting the photomask as described above, namely forming a light absorbing member which absorbs the light emitted from the light source, having the same shape as the light-shielding pattern, on the surface of the photomask opposed to the sample substrate, the above light is irradiated only to a predetermined portion of the polymer film, and therefore the predetermined pattern can be formed with a good precision in the polymer film.

The present invention is described in more detail by referred to Examples.

### Example 1

After a material to be worked was obtained by forming an amorphous silicon film with a film thickness of 400 nm (4000Å) on a silicon wafer as the substrate according to the CVD method at a substrate temperature of 250°C, hydrogen gas was ionised by use of the ECR plasma method at a vacuum degree of 10⁻¹ Pa (10⁻³ Torr)or less, and irradiated to the amorphous silicon film surface formed on the material to be worked, thereby effecting the surface modification.

Next, the material to be worked was set at the setting position of the material to be worked in the apparatus shown in Fig. 2.

After vacuum evacuation internally of the vacuum tank to 10⁻⁴ Pa (10⁻⁶ Torr) or less, CF₄ gas was permitted to flow in through the gas introducing pipe 417 at 500 SCCM and a power of 700 W was thrown by the magnetron 418 to excite microwaves, which were introduced through the transporting pipe 420 into the vacuum tank 402 to form a polymerized film on the amorphous silicon film of the material to be worked. The gas pressure during the operation was 33 Pa (0.25 Torr), and the film formation time 2 minutes.

Next, NO₂ gas was permitted to flow in through the gas introducing pipe 404 at 100 SCCM, and by use of an argon ion laser as the laser beam source 410, continuous irradiation was effected under the conditions of an output of 1 W, a spot diameter of 50 µm, a parallel scanning speed of 20 cm/sec. and a delivery speed of the material to be worked of 2 mm/sec., and the polymerized film at the photoirradiated portion was selectively removed by decomposition with oxygen radicals formed by photoexcitation to obtain a state in which the resist pattern comprising a band-shaped polymerized film and the exposed portion of an amorphous silicon film juxtaposed in stripes.

When unnecessary gas, etc. was removed from within the vacuum tank 402 by the evacuation device 403, Cl₂ was introduced at 800 SCCM through the gas introducing pipe 417, microwave was excited by the magnetron 418 to form chlorine radicals, which were introduced through the transporting pipe 420 into the vacuum tank 402, followed by etching treatment of the surface where the resist pattern of the amorphous silicon film was provided for 5 minutes.

After completion of the etching treatment, oxygen gas was introduced through the gas introducing pipe 404 to generate a plasma from the plasma generators 405 and 405', thereby effecting ashing of the polymerized film to remove the resist pattern comprising the polymerized film on the surface of the amorhous silicon film subjected to the etching treatment.

After completion of the steps as described above, the material to be worked was taken out from the vacuum tank, and the etching depth of the etched portion was measured by Taristep manufactured by Hobson-Taylor Company.

As the result, it was confirmed that the non-irradiated portion was not etched, but the irradiated portion was etched, but the irradiated portion was etched with a depth of 300 nm (3000Å).

Also as the result of the surface observation, a continuous uneven pattern corresponding to the photoirradiated portion and the unirradiated portion arranged in stripes was observed.

### Example 2

A material to be worked was obtained by forming an al film with a thickness of 200 nm (2000Å) on a silicon wafer as the substrate according to the sputtering method.

The material to be worked was set at the setting position of the material to be worked in the apparatus shown in Fig. 1, the vacuum tank was placed under a vacuum degree of 10⁻⁴ Pa (10⁻⁶ Torr) or lower, an argon gas permitted to flow through the gas introducing pipe 404 into the vacuum tank 402 at 20 SCCM to generate a plasma from the plasma generators 405 and 405', and the Al film of the material to be worked was exposed to the plasma atmosphere generated for 20 minutes, thereby cleaning its surface.

Next, CF₃Cl gas was permitted to flow in through the gas introducing pipe 417 at a flow rate of 500 SCCM and a power of 700 W applied by the magnetron 418 to excite microwaves, which were introduced through the transporting pipe 420 into the vacuum tank 402 to form a polymerized film on the Al film of the material to be worked.

Next, oxygen gas was permitted to flow through the gas introducing pipe 404 at 100 SCCM, and by use of an ArF excimer laser as the light source 406, pattern exposure was effected at a laser oscillation frequency of 50 Hz through an exposure mask 408 for 5 minutes.

Then, Cl₂ gas was introduced as the gas for etching through the introducing pipe 417 at 500 SCCM, excited by the magnetron 418 to form chlorine radicals,which were introduced through the transporting pipe 420 into the vacuum tank 402 and etching treatment was carried out for 10 minutes.

After completion of the etching treatment, the material to be worked was taken out from the vacuum tank, and its surface was observed. As the result, at the portion photoirradiated through the exposure mask, the Al film was found to be etched to expose the silicon wafer of the substrate, while the Al film protected with the polymerized film remain without etching at the non-irradiated portion.

## Claims

1. A process of forming an etching pattern in which a resist pattern is formed on a surface of a member, and the surface of the member is etched with the formed resist pattern as a mask to form the etching pattern in the member, the process comprising the following sequence of consecutive steps:
a step of forming a film of resist material by forming a polymer film incapable of being etched with halogen element radicals on the surface of the member by chemical vapour deposition using, as starting material, a compound obtained by substituting a part or all of the hydrogen atoms constituting a hydrocarbon compound with at least one selected from fluorine or chlorine;
a step of forming a resist pattern which includes selectively irradiating a portion of the formed polymer film, that is to be removed, with light, whereby the polymer film is patterned into a desired pattern; and
a step of dry etching the surface of the member exposed by the resist pattern using the polymer film resist pattern as a mask and utilising halogen element radicals as etchant species;
**characterised in that** said process is an all-dry process in which:
said step of forming the film of resist material is preceded by a step of cleaning or modifying the surface of the member, which comprises cleaning the surface of the member with a plasma obtained using either hydrogen gas or an inert gas or modifying the surface of the member by irradiating it with hydrogen ions or fluorine ions;
said step of forming the resist pattern is performed by selectively irradiating said portion of the formed polymer film in an atmosphere, generating oxygen radicals to decompose and remove the light irradiated portion of the polymer film with the radicals generated by the light irradiation; and
said sequence of steps, including said step of cleaning or modifying the surface of the member, is performed in a state continuously shielded from air and under reduced pressure.

2. A process for forming an etching pattern according to claim 1, wherein the atmosphere comprises at least one of oxygen, nitrogen dioxide, ozone, nitrous oxide, and carbon dioxide.

3. A process according to either preceding claim, wherein said step of dry etching is performed by using a compound capable of generating halide radicals.

4. A process according to claim 3, wherein said halide radicals are selected from the group consisting of chloride radicals and fluoride radicals.

5. A process according to claim 4, wherein said compound is selected from CF₃Cl, CCl₄ and NF₃.

6. A process according to either of claims 1 or 2, wherein said step of dry etching is performed by using chlorine.

7. A process according to any preceding claim, wherein said light irradiation is effected through a photomask.

8. A process according to claim 7, wherein said photomask has a light shielding pattern and a light absorbing member provided corresponding to said light shielding pattern.

9. A process according to any preceding claim, wherein the step of forming the resist pattern and the step of dry etching are carried out in different treatment spaces.

10. A process according to claim 9, wherein the member is moved between said different treatment spaces via a conveying chamber adjacent to each of said treatment spaces.

11. A process according to claim 10, wherein the member is moved through a gate valve provided between said conveying chamber and each of said treatment spaces.

12. A process according to any preceding claim, wherein the surface of said member is of Al, Si, Cr, Au, CdS, GaAs or Ge.

13. A process of producing a semiconductor device comprising steps of:
forming an etching pattern in the semiconductor device material surface of a substrate member; and
completing manufacture of the semiconductor device; wherein
the step of forming said etching pattern is performed by the process of any of the preceding claims 1 to 12.

## Patentansprüche

1. Verfahren zum Bilden eines Ätzmusters, in welchem ein Resistmuster auf einer Oberfläche eines Elements gebildet wird, und die Oberfläche des Elements mit dem gebildeten Resistmuster als eine Maske geätzt wird, um das Ätzmuster in dem Element zu bilden, wobei das Verfahren die folgende Abfolge von aufeinanderfolgenden Schritten umfasst:
einen Schritt des Bildens eines Films aus Resistmaterial, in dem ein Polymerfilm gebildet wird, der nicht mit Hologenelement-Radikalen auf der Oberfläche des Elements durch chemische Dampfabscheidung geätzt werden kann, wobei als Ausgangsmaterial eine Verbindung verwendet wird, die durch Ersetzen eines Teils oder eine Kohlenwasserstoffverbindung zusammensetzenden Wasserstoffatome durch wenigstens eines ausgewählt aus Fluor oder Chlor erhalten wurde;
einen Schritt des Bildens eines Resistmusters, welcher einschließt: selektives Belichten eines Teils des gebildeten Polymerfilms, der entfernt wird, wobei der Polymerfilm in ein gewünschtes Muster gemustert wird; und
einen Schritt des Trockenätzens der Oberfläche des Elements, das durch ein Resistmuster ausgesetzt wird, wobei das Polymerfilmresistmuster als eine Maske verwendet verwendet wird und Hologenelementradikale als Ätzspezies verwendet werden;
**dadurch gekennzeichnet, dass** das Verfahren ein vollständig trockenes Verfahren ist, in welchem:
dem Schritt des Bildens des Films aus Resistmaterial ein Schritt des Reinigens oder Modifizieren der Oberfläche des Elements vorausgeht, welches umfasst:
Reinigen der Oberfläche des Elements mit einem Plasma, das unter Verwendung von entweder Wasserstoffgas oder einem Inertgas erhalten wurde, oder Modifizieren der Oberfläche des Elements, indem diese mit Wasserstoffionen oder Fluorionen bestrahlt wird;
der Schritt des Bildens des Resistmusters ausgeführt wird, indem selektiv der Teil des gebildeten Polymerfilms in einer Atmosphäre bestrahlt wird, wobei Sauerstoffradikale erzeugt werden, um den Licht bestrahlten Teil des Polymerfilms mit den durch die Lichtbestrahlung erzeugten Radikalen zu zersetzen und zu entfernen; und
die Abfolge von Schritten, einschließlich dem Schritt des Reinigens und Modifizierens der Oberfläche des Elements, in einem Zustand ausgeführt wird, der kontinuierlich von Luft abgeschirmt ist und unter reduziertem Druck steht.

2. Verfahren zum Ausbilden eines Ätzmusters gemäß Anspruch 1, wobei die Atmosphäre wenigstens eines aus Sauerstoff, Stickstoffdioxid, Ozon, Stickstoffoxid und Kohlendioxid umfasst.

3. Verfahren gemäß einem der vorhergehenden Ansprüche, wobei der Schritt des Trockenätzens ausgeführt wird, indem eine Verbindung verwendet wird, die Halidradikale erzeugen kann.

4. Verfahren gemäß Anspruch 3, wobei die Halidradikale ausgewählt sind aus der Gruppe bestehend aus Chloridradialen und Fluoridradikalen.

5. Verfahren gemäß Anspruch 4, wobei die Verbindung ausgewählt ist aus CF₃Cl, CCl₄ und NF₃.

6. Verfahren gemäß einem der Ansprüche 1 oder 2, wobei der Schritt des Trockenätzens ausgeführt wird, indem Chlor verwendet wird.

7. Verfahren gemäß einem der vorhergehenden Ansprüche, wobei die Lichtbestrahlung durch eine Fotomaske ausgeführt wird.

8. Verfahren gemäß Anspruch 7, wobei die Fotomaske ein Lichtabschirmungsmuster und ein Licht absorbierendes Element besitzt, das entsprechend den Lichtabschirmungsmuster bereitgestellt wird.

9. Verfahren gemäß einem der vorhergehenden Ansprüche, wobei der Schritt des Ausbildens des Resistmusters und der Schritt des Trockenätzens in verschiedenen Behandlungsräumen ausgeführt werden.

10. Verfahren gemäß Anspruch 9, wobei das Element zwischen den verschiedenen Behandlungsräumen über eine Beförderungskammer bewegt wird, die zu jedem der Behandlungsräume benachbart ist.

11. Verfahren gemäß Anspruch 10, wobei das Element durch ein Gate-Ventil bewegt wird, das zwischen der Beförderungskammer und jedem der Behandlungsräume bereitgestellt wird.

12. Verfahren gemäß einem der vorhergehenden Ansprüche, wobei die Oberfläche des Elements aus Al, Si, Cr, Au, CdS, GaAs oder Ge ist.

13. Verfahren zum Herstellen einer Halbleitervorrichtung, das die folgenden Schritte umfasst:
Ausbilden eines Ätzmusters in der Halbleitervorrichtungsmaterialoberfläche eines Substratelements; und
Vervollständigen der Herstellung der Halbleitervorrichtung; wobei
der Schritt des Ausbildens des Ätzmusters durch das Verfahren gemäß einem der vorhergehenden Ansprüche 1 bis 12 ausgeführt wird.

## Revendications

1. Procédé pour former un motif d'attaque, dans lequel un motif de résist est formé sur une surface d'un élément, et la surface de l'élément est attaquée avec le motif de résist formé comme masque pour former le motif d'attaque dans l'élément, procédé comprenant la séquence suivante d'étapes consécutives :
une étape consistant à former un film d'une matière de résist en formant un film de polymère ne pouvant être attaqué avec des radicaux d'éléments consistant en halogènes sur la surface de l'élément par dépôt chimique en phase vapeur en utilisant, comme matière de départ, un composé obtenu par substitution d'une partie ou de la totalité des atomes d'hydrogène constituant un composé hydrocarboné par au moins un atome choisi entre le fluor et le chlore ;
une étape consistant à former un motif de résist, qui comprend l'irradiation sélective d'une partie du film de polymère formé, qui doit être éliminée, avec de la lumière, ce qui fait que le film de polymère est muni d'un motif désiré ; et
une étape d'attaque à sec de la surface de l'élément exposée par le motif de résist en utilisant le motif de résist de film de polymère comme masque et en utilisant des radicaux d'éléments consistant en halogènes comme entités d'attaque ;
ledit procédé étant **caractérisé en ce qu'**il consiste en un procédé mis en oeuvre totalement à sec dans lequel :
ladite étape consistant à former le film de matière de résist est précédée d'une étape consistant à nettoyer ou modifier la surface de l'élément, qui comprend le nettoyage de la surface de l'élément avec un plasma obtenu en utilisant de l'hydrogène gazeux ou un gaz inerte ou en modifiant la surface de l'élément en l'irradiant avec des ions hydrogène ou des ions fluor ;
ladite étape consistant à former le motif de résist est mise en oeuvre en irradiant sélectivement ladite partie du film de polymère formé dans une atmosphère engendrant des radicaux oxygène pour décomposer et éliminer la partie irradiée par la lumière du film de polymère avec les radicaux engendrés par l'irradiation par la lumière ; et
ladite séquence d'étapes, comprenant l'étape de nettoyage ou de modification de la surface de l'élément, est mise en oeuvre à l'état de protection continue contre le contact avec l'air et sous pression réduite.

2. Procédé pour former un motif d'attaque suivant la revendication 1, dans lequel l'atmosphère comprend au moins une des substances consistant en l'oxygène, le dioxyde d'azote, l'ozone, l'oxyde nitreux et le dioxyde de carbone.

3. Procédé suivant l'une des revendications précédentes, dans lequel l'étape d'attaque à sec est mise en oeuvre en utilisant un composé capable d'engendrer des radicaux halogénure.

4. Procédé suivant la revendication 3, dans lequel les radicaux halogénure sont choisis dans le groupe consistant en des radicaux chlorure et des radicaux fluorure.

5. Procédé suivant la revendication 4, dans lequel le composé est choisi entre CF₃Cl, CCl₄ et NF₃.

6. Procédé suivant une des revendications 1 et 2, dans lequel l'étape d'attaque à sec est mise en oeuvre en utilisant du chlore.

7. Procédé suivant l'une quelconque des revendications précédentes, dans lequel l'irradiation par de la lumière est effectuée à travers un photomasque.

8. Procédé suivant la revendication 7, dans lequel le photomasque possède un motif de protection contre la lumière et un élément absorbant la lumière présent de manière à correspondre audit motif de protection contre la lumière.

9. Procédé suivant l'une quelconque des revendications précédentes, dans lequel l'étape de formation du motif de résist et l'étape d'attaque à sec sont mises en oeuvre dans des espaces de traitement différents.

10. Procédé suivant la revendication 9, dans lequel l'élément est déplacé entre les espaces de traitement différents par une chambre de transport adjacente à chacun desdits espaces de traitement.

11. Procédé suivant la revendication 10, dans lequel l'élément est déplacé à travers une vanne à obturateur présente entre la chambre de transport et chacun des espaces de traitement.

12. Procédé suivant l'une quelconque des revendications précédentes, dans lequel la surface de l'élément est constituée de Al, Si, Cr, Au, CdS, GaAs ou Ge.

13. Procédé pour la production d'un dispositif semiconducteur, comprenant les étapes consistant :
à former un motif d'attaque dans la surface de la matière d'un élément servant de substrat du dispositif semiconducteur ; et
à achever la production du dispositif semiconducteur ;
dans lequel
l'étape de formation dudit motif d'attaque est mise en oeuvre par le procédé suivant l'une quelconque des revendications 1 à 12 précédentes.
